(19) Europäisches Patentamt
European Patent Office
Office européen des brevets

(11) **EP 2 846 366 B1**

(12) **FASCICULE DE BREVET EUROPEEN**

(45) Date de publication et mention
de la délivrance du brevet:
**11.10.2017 Bulletin 2017/41**

(51) Int Cl.:
***H01L 33/22*** *(2010.01)*     ***H01L 33/38*** *(2010.01)*

(21) Numéro de dépôt: **14183946.4**

(22) Date de dépôt: **08.09.2014**

(54) **Diode électroluminescente à cristaux photoniques localisés**

Elektrolumineszenzdiode mit lokalisierten Photonenkristallen

Light-emitting diode with localised photonic crystals

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.09.2013 FR 1302094**

(43) Date de publication de la demande:
**11.03.2015 Bulletin 2015/11**

(73) Titulaire: **Commissariat à l'Energie Atomique et
aux Energies
Alternatives
75015 Paris (FR)**

(72) Inventeurs:
- **Reboud, Vincent**
  **75013 Paris (FR)**
- **Landis, Stefan**
  **38210 TULLINS (FR)**
- **Gaillard, Frédéric-Xavier**
  **38500 Voiron (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
**US-A1- 2005 173 717**     **US-A1- 2008 043 795**

## Description

### Domaine technique de l'invention

L'invention est relative à une diode électroluminescente de forte puissance, et plus particulièrement à une diode dont l'extraction de lumière est améliorée à l'aide d'un cristal photonique.

### État de la technique

Les diodes électroluminescentes (LED) connaissent un essor important, notamment dans le domaine de l'éclairage, en raison de leur grande efficacité énergétique. Dans la catégorie des LED dites planaires ou « 2D » en référence au plan d'émission de la lumière, on distingue deux types de structure : la structure latérale de type MESA et la structure verticale.

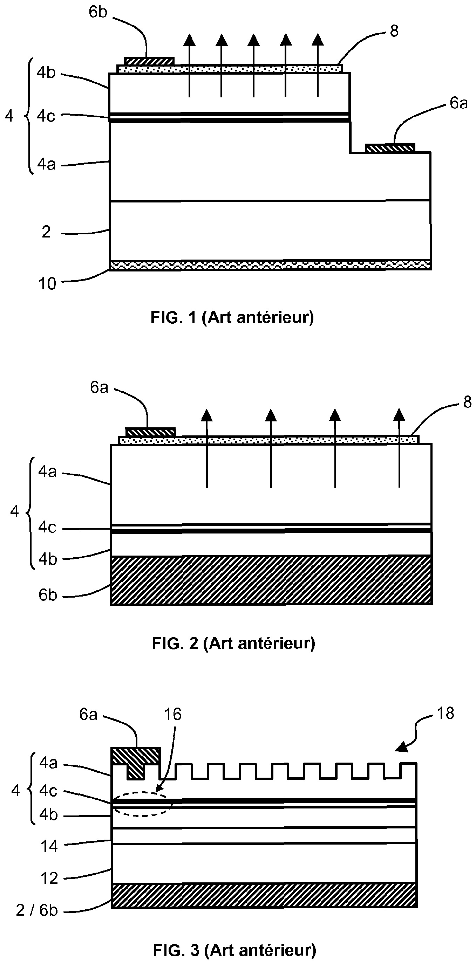

La figure 1 représente, en vue de coupe, une diode électroluminescente à structure de type MESA. La LED MESA comporte un substrat de croissance 2 sur lequel est formé un empilement 4 de couches en matériaux semi-conducteurs. Les matériaux utilisés sont par exemple les semi-conducteurs III-V à base de nitrure de gallium (GaN, InGaN, AlGaN...). La longueur d'onde d'émission de la LED se situe alors dans le bleu, autour de 460 nm.

L'empilement 4 comprend classiquement une couche 4a en GaN dopé de type n en contact avec le substrat 2, une couche 4b en GaN dopé de type p et une zone active 4c disposée entre les couches 4a et 4b. La zone active 4c est formée de puits quantiques en InGaN et correspond à la zone d'émission des photons. Les couches 4a à 4c en GaN et InGaN sont épitaxiées sur le substrat de croissance 2, par exemple en saphir ($Al_2O_3$).

Deux électrodes 6a et 6b permettent d'injecter un courant électrique dans la LED. La cathode 6a est disposée sur la couche 4a de type n, au fond d'un puits gravé dans les couches semi-conductrices 4a à 4c. L'anode 6b, en contact électrique avec la couche 4b de type p, est située sur la partie surélevée de la LED (qu'on appelle la mesa).

Une couche de contact 8 en matériau électriquement conducteur est située sous l'électrode 6b. La couche 8 vise à améliorer le contact électrique entre l'électrode 6b et la couche 4b sous-jacente, en étalant le courant sur toute la surface de la couche 4b. Cela favorise une injection homogène du courant à travers la zone active 4c.

La lumière émise dans la LED est soit extraite par le bas, au travers du substrat en saphir (également transparent à la longueur d'onde d'émission), soit par le haut, au travers de la couche de contact 8. Dans le second cas, représenté sur la figure 1, le matériau de la couche 8 est un oxyde conducteur transparent à la longueur d'onde d'émission, par exemple l'oxyde d'indium et d'étain (ITO). Un miroir 10 peut recouvrir la face inférieure du substrat 2, de façon à réfléchir la lumière émise depuis la couche 4c en direction du substrat.

Dans la configuration de la figure 1, les électrodes 6a et 6b sont situées du même côté du substrat 2. Cette structure de LED est la plus simple à fabriquer car le substrat de croissance est conservé. À l'inverse, dans la structure verticale décrite ci-dessous, le substrat de croissance des couches à base de GaN est retiré et remplacé par un substrat métallique jouant le rôle d'électrode.

La figure 2 est une vue en coupe d'une diode électroluminescente à architecture verticale. L'empilement de couches semi-conductrices sur le substrat est ici renversé. La couche 4a de GaN dopé n correspond à la partie supérieure de la LED et la couche 4b de GaN dopé p est en contact avec le substrat. La cathode 6a est disposée sur la couche 4a et le substrat, en métal, forme l'anode 6b.

La lumière est émise principalement dans la zone active 4c composée de puits quantiques ou d'hétérostructures. Elle est ensuite extraite par le haut au travers de la couche 4a. Le substrat métallique 6b sert également de miroir pour réfléchir la portion de rayonnement dirigée vers le bas. Comme sur la figure 1, cette structure peut disposer d'une couche de contact 8 en un matériau conducteur et transparent, afin d'améliorer l'injection du courant.

Dans ces deux types de LED GaN, seulement 5 % du rayonnement lumineux est émis perpendiculairement au plan de la LED et extrait efficacement de la structure. La majeure partie du rayonnement est piégée dans les couches de haut indice optique (GaN, InGaN) et se propage dans des plans parallèles au substrat par réflexion interne totale. Cette lumière guidée doit être également extraite afin d'obtenir des LED de haute brillance.

Une première technique pour améliorer l'extraction de lumière consiste à texturer la surface de la couche supérieure en GaN (dans le cas d'une émission par le haut), c'est-à-dire la couche 4b dans l'exemple de la figure 1 ou la couche 4a dans l'exemple de la figure 2. Cette texturation est obtenue par une gravure humide et se présente généralement sous la forme de pyramides ou de pores de taille aléatoire. Une solution d'acide fluorhydrique (HF) et de persulfate de potassium ($K_2S_2O_8$) sous illumination UV est, par exemple, proposée dans le document ["Metal-assisted electroless fabrication of nanoporous p-GaN for increasing the light extraction efficiency of light emitting diodes", R. Wang et al., AIP Advances 2, 012109, 2012].

Cette rugosité de surface porte à 60 % la part du rayonnement extrait de la LED. Une lentille en forme de dôme peut encapsuler la LED afin d'améliorer encore l'extraction de lumière (jusqu'à 80 % du rayonnement émis). Ce dôme redirige la lumière émise par les tranches de la LED.

Au lieu de structurer aléatoirement la couche de GaN en surface, une deuxième approche consiste à graver des trous en profondeur et régulièrement espacés de manière à former un cristal photonique. Un cristal photonique est une structure périodique à l'échelle de la longueur d'onde avec un fort contraste d'indice optique dans une, deux ou trois directions de l'espace. Il permet d'extraire par diffraction une grande partie de la lumière guidée. En outre, il permet de contrôler le diagramme d'émission de la lumière, en particulier les angles du cône d'extraction. Il en résulte une augmentation de la brillance de la LED par un facteur deux en comparaison avec une surface texturée de manière aléatoire.

Les couches semi-conductrices de la diode électroluminescente sont obtenues par épitaxie sur le substrat de croissance. Les couches situées entre le substrat et la zone active sont épaisses, de quelques centaines de nanomètres et une dizaine de micromètres, afin d'obtenir une croissance sans défaut de la zone active. En général, une couche tampon (« buffer layer » en anglais) permet l'adaptation du paramètre de maille entre le substrat et la zone active et concentre les défauts de croissance, tels que des dislocations.

A cause de ces contraintes géométriques, le guidage de la lumière dans les plans de la LED est multimode. Autrement dit, l'énergie lumineuse est répartie dans un mode fondamental, d'ordre égal à 1, et dans des harmoniques, d'ordres supérieurs à 1. Le mode fondamental, qui contient en général le plus d'énergie lumineuse, est contenu dans la zone active tandis les modes d'ordres supérieurs sont guidés par une autre couche de la LED, voire plusieurs couches.

Afin d'extraire la lumière couplée dans différents modes, il convient de graver des cristaux photoniques profonds, de l'ordre de la centaine de nanomètres dans le cas des LEDs MESA, à plusieurs micromètres dans le cas des LEDs verticale, jusqu'à la zone active et parfois même au-delà. Toutefois, cette gravure est difficile à réaliser et la structuration proche de la zone active accroît les pertes par recombinaisons non-radiatives.

Le document US2006/0192217 propose en outre de contrôler les modes d'émission de la lumière guidée, afin d'augmenter la proportion de lumière extraite par le cristal photonique.

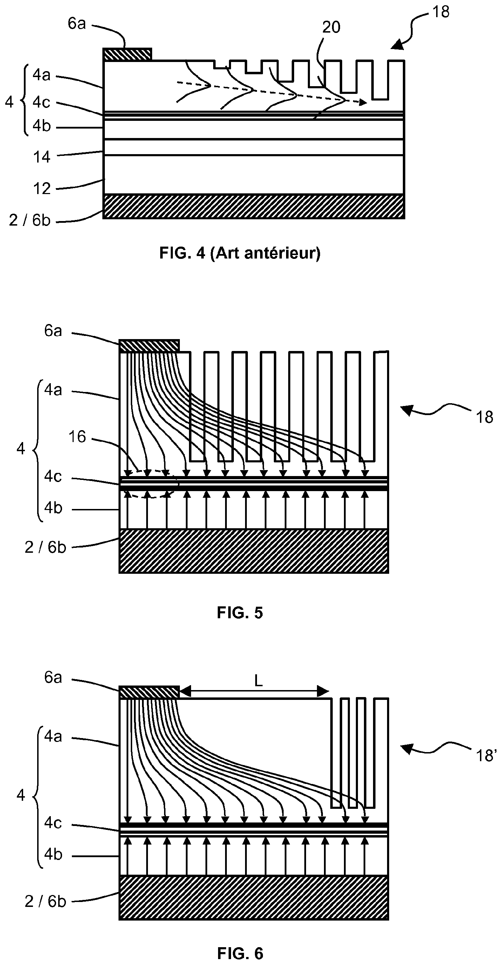

Les figures 3 et 4 représentent schématiquement deux variantes de LED verticale à l'émission de lumière contrôlée, d'après l'enseignement du document US2006/0192217.

Chaque LED comprend, en plus du substrat de croissance 2 et de l'empilement 4 de couches en GaN ou InGaN, une couche tampon 12 et une couche de confinement optique 14 en AlGaN. Les couches 12 et 14 sont situées entre le substrat de croissance 2 et la couche 4b dopée de type p.

Après la croissance successive des couches 12, 14, 4b, 4c et 4a sur le substrat 2, un cristal photonique 18 est gravé dans la partie supérieure de la couche 4a, à l'opposé du substrat 2. Puis, une électrode 6a est formée sur la couche 4a de GaN. Le substrat de croissance 2 est retiré et remplacé par une électrode métallique 6b, finalisant ainsi la structure verticale de la LED. La couche de confinement 14 en AlGaN dispose d'un indice optique plus faible que celui des couches adjacentes 12 et 4b en GaN. Cela favorise les modes optiques se propageant dans les couches situées à proximité du cristal photonique 18 (couches 4a, 4b et puits quantiques 4c), au détriment des modes situés en dessous de la couche de confinement 14 (i.e. dans la couche tampon 12). Ainsi, la lumière guidée est émise principalement dans des modes ayant un bon recouvrement avec le cristal photonique.

Dans la structure de la figure 3, l'électrode 6a est située au niveau du cristal photonique 18. Ainsi, la zone 16 des puits quantiques 4c, située à l'aplomb de l'électrode 6a et dans laquelle les recombinaisons radiatives sont les plus fortes, coïncide avec le cristal photonique. Cela permet d'extraire immédiatement la lumière émise dans la zone 16, avant même qu'elle se propage transversalement dans la LED.

Par contre, lorsque l'électrode 6a est disposée en dehors du cristal photonique, comme cela est représenté en figure 4, il convient d'adapter la géométrie du cristal photonique de façon à optimiser le couplage optique entre la lumière guidée (représentée par une onde en déplacement) et le cristal photonique 18. On évite ainsi qu'une partie de la lumière guidée soit réfléchie par les parois du cristal 18.

Pour cela, le document US2006/0192217 propose de graver des trous 20 dont le diamètre, la période et/ou la profondeur varie progressivement (Fig.4). Toutefois, une variation fine de ces paramètres géométriques est difficile à obtenir avec les techniques classiques de gravure sèche des cristaux photoniques (type plasma). Ce cristal photonique à géométrie optimisée n'est donc, en pratique, que peu utilisé.

En contrepartie d'une meilleure extraction de lumière, la couche de confinement 14 du document US2006/0192217 augmente considérablement la résistance électrique et la tension de fonctionnement de la LED. Une telle couche introduit en outre des dislocations dans les couches supérieures en GaN, à cause de la différence entre leurs paramètres de maille. Or, ces dislocations sont préjudiciables pour le rendement de la LED car elles agissent comme centres de recombinaisons non-radiatives.

## Résumé de l'invention

On constate qu'il existe un besoin de prévoir une diode électroluminescente disposant à la fois d'une bonne extraction de lumière et de bonnes propriétés électriques.

On tend à satisfaire ce besoin en prévoyant une diode électroluminescente munie des éléments suivants :

- une première couche en matériau semi-conducteur dopé d'un premier type de conductivité ;
- une deuxième couche en matériau semi-conducteur dopé d'un second type de conductivité opposé ;
- une zone active électroluminescente située entre les première et deuxième couches en matériau semi-conducteur ;
- une électrode disposée sur la première couche en matériau semi-conducteur ; et
- un cristal photonique formé dans la première couche en matériau semi-conducteur.

Le cristal photonique et l'électrode sont séparés d'une distance L vérifiant, avec une précision de 10 %, l'équation suivante :

$$L = \frac{L_S}{\alpha L_S - 1} \ln\left(\frac{(\eta_B - \eta_A)\cdot \alpha L_S}{\eta_B - \eta_A \alpha L_S}\right)$$

dans laquelle :

- $L_S$ est la distance, depuis l'électrode, à laquelle la densité de courant dans la zone active électroluminescente est égale à la densité de courant sous l'électrode divisée par e ;
- $\alpha$ est le coefficient d'absorption des modes de lumière se propageant dans les première et deuxième couches en matériau semi-conducteur et dans la zone active électroluminescente ;
- $\eta_A$ est le coefficient d'extraction de lumière dans une portion des première et deuxième couches en matériau semi-conducteur et de la zone active électroluminescente, située entre l'électrode et le cristal photonique ; et
- $\eta_B$ est le coefficient d'extraction de lumière dans la zone du cristal photonique.

Afin d'homogénéiser le courant électrique dans la zone active, l'électrode peut comporter une pluralité de pistes électriquement conductrices. Le cristal photonique comporte alors avantageusement une pluralité de zones d'extraction de lumière réparties dans la première couche en matériau semi-conducteur, chaque zone d'extraction étant comprise entre deux pistes électriquement conductrices.

Selon un développement, chaque zone d'extraction est située à équidistance des deux pistes électriquement conductrices.

Selon un autre développement, la répartition des zones d'extraction dans la première couche en matériau semi-conducteur est périodique.

De préférence, deux zones d'extraction consécutives sont séparées d'une distance inférieure à la distance moyenne parcourue par des photons avant absorption dans le matériau semi-conducteur.

Le cristal photonique comporte préférentiellement des trous espacés périodiquement et s'étendant à travers la première couche en matériau semi-conducteur jusqu'à la zone active électroluminescente.

Avantageusement, les trous du cristal photonique s'étendent également à travers la zone active électroluminescente.

On prévoit, en outre, un procédé simple et rapide à mettre en oeuvre pour réaliser une diode électroluminescente avec un cristal photonique optimisé.

Le procédé comprend les étapes suivantes : prévoir une première couche en matériau semi-conducteur dopé d'un premier type de conductivité, une deuxième couche en matériau semi-conducteur dopé d'un second type de conductivité opposé et une zone active électroluminescente située entre les première et deuxième couches en matériau semi-conducteur ; former une électrode sur la première couche en matériau semi-conducteur, et graver un cristal photonique dans la première couche en matériau semi-conducteur.

Le cristal photonique et l'électrode sont séparés d'une distance L vérifiant, avec une précision de 10 %, l'équation suivante :

$$L = \frac{L_S}{\alpha L_S - 1} \ln\left(\frac{(\eta_B - \eta_A)\cdot \alpha L_S}{\eta_B - \eta_A \alpha L_S}\right)$$

dans laquelle :

- $L_S$ est la distance, depuis l'électrode, à laquelle la densité de courant dans la zone active électroluminescente est égale à la densité de courant sous l'électrode divisée par e ;

- $\alpha$ est le coefficient d'absorption des modes de lumière se propageant dans les première et deuxième couches en matériau semi-conducteur et dans la zone active électroluminescente ;

- $\eta_A$ est le coefficient d'extraction de lumière dans une portion des première et deuxième couches en matériau semi-conducteur et de la zone active électroluminescente, située entre l'électrode et le cristal photonique ; et

- $\eta_B$ est le coefficient d'extraction de lumière dans la zone du cristal photonique.

Le cristal photonique peut être gravé au travers d'un masque comportant une pluralité d'évidements, d'où il résulte une pluralité de zones d'extraction de lumière réparties dans la première couche en matériau semi-conducteur.

L'électrode peut être formée d'une pluralité de pistes électriquement conductrices, une piste étant disposée entre chaque couple de zones d'extraction consécutives.

Dans un mode de mise en oeuvre préférentiel, la gravure du cristal photonique est obtenue par dissolution anodique sous ultraviolets de la couche en matériau semi-conducteur.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 représente schématiquement une LED à structure MESA selon l'art antérieur ;

- la figure 2 représente schématiquement une diode électroluminescente (LED) à structure verticale selon l'art antérieur ;

- les figures 3 et 4 représentent deux variantes de réalisation d'une LED verticale munie d'un cristal photonique selon l'art antérieur ;

- la figure 5 représente schématiquement l'injection électrique dans la LED de la figure 3 ;

- la figure 6 représente un mode de réalisation générique d'une LED verticale munie d'un cristal photonique localisé selon l'invention, et l'injection électrique dans cette LED ;

- la figure 7 représente schématiquement l'évolution de la densité de courant dans la LED de la figure 6 ;

- la figure 8 est un graphique de l'intensité lumineuse extraite par une LED verticale en fonction de la distance entre l'électrode et le cristal photonique, pour différentes valeurs d'absorption de lumière ;

- la figure 9 est une vue en coupe d'une portion de LED verticale à cristaux photoniques localisés selon l'invention ;

- la figure 10 est une vue en coupe d'une variante de réalisation de la LED de la figure 9 ;

- la figure 11 est une vue en coupe d'une autre variante de réalisation de la LED des figures 9 et 10 ;

- la figure 12 est une vue complète de dessus d'une LED verticale à cristaux photoniques localisés selon l'invention ;

- la figure 13 est une autre représentation en vue de dessus d'une LED verticale à cristaux photoniques localisés selon l'invention ;

- les figures 14A à 14D représentent schématiquement différentes géométries de cristal photonique ;

- les figures 15, 16 et 18 représente des étapes d'un procédé de réalisation d'une LED à cristaux photoniques localisés selon l'invention ;

- la figure 17 représente schématiquement une étape de gravure des cristaux photoniques par dissolution anodique sous ultraviolets ; et

- la figure 19 représente une variante de mise en oeuvre de l'étape de la figure 15.

**Description d'un mode de réalisation préféré de l'invention**

Dans la description qui suit, on prendra l'exemple d'une diode électroluminescente (LED) plane à structure verticale, dans laquelle la lumière est extraite par le haut, à l'opposé du substrat. Comme cela a été décrit en relation avec la figure 2, cette LED comporte un empilement 4 de couches en matériau semi-conducteur et deux électrodes, 6a et 6b, de part et d'autre de l'empilement. L'empilement 4 comprend, par exemple, une couche 4a en GaN dopé de type n, une couche 4b en GaN dopé de type p, et une zone active électroluminescente 4c située entre les couches 4a et 4b. La zone active 4c est, de préférence, formée de puits quantiques InGaN/GaN, c'est-à-dire de couches en InGaN alternant avec des couches en GaN.

La figure 5 illustre l'injection du courant électrique dans la diode électroluminescente à structure verticale, et plus particulièrement les lignes de courant entre les électrodes 6a et 6b. Les flèches situées dans la couche semi-conductrice 4a symbolisent le parcours des électrons en provenance de la cathode 6a tandis que les flèches de la couche semi-conductrice 4b symbolisent le parcours des trous provenant de l'anode 6b. Électrons et trous se rejoignent dans la zone active 4c et se recombinent en générant des photons.

Dans cet exemple de diode, l'électrode supérieure 6a est localisée sur un bord de la LED (à gauche sur la figure 5). Elle présente donc, en vue de coupe, une première paroi latérale alignée avec un bord de l'empilement 4 et une deuxième paroi latérale en retrait par rapport à un bord opposé de l'empilement 4. L'électrode inférieure 6b est formée d'un substrat électriquement conducteur, par exemple en métal, rapporté sur la LED après retrait du substrat de croissance 2. L'électrode 6b occupe toute la surface de la LED, à l'inverse de l'électrode 6a.

Comme indiqué précédemment, les recombinaisons radiatives sont plus nombreuses dans une portion 16 de la zone active 4c située à l'aplomb de l'électrode supérieure 6a. Cela est dû à une forte densité de courant électrique sous l'électrode 6a. Par contre, plus on s'éloigne latéralement de l'électrode 6a, plus la densité de courant diminue. Le courant électrique dans la couche 4a et dans la zone active 4c est donc inhomogène. Cette inhomogénéité est schématisée par un trajet des électrons de plus en plus long sur la figure 5.

Dans le document US2006/0192217, la LED verticale comporte en outre un cristal photonique pour améliorer l'extraction de lumière. Pour évaluer l'influence du cristal photonique sur l'injection électrique, on a superposé le cristal photonique 18 aux lignes de courant de la figure 5. Le cristal 18 est formé dans une portion significative de la couche 4a en GaN, à côté de la cathode 6a. On constate alors que le cristal photonique va empêcher le transport des électrons et perturber l'injection électrique. Il en résulte une diminution de la densité de courant dans la zone active électroluminescente et, par conséquent, du nombre de photons générés.

Ainsi, l'injection du courant électrique dans la zone active électroluminescente d'une LED peut être fortement détériorée par un cristal photonique, si l'on ne prend pas garde au positionnement de l'électrode par rapport à ce cristal photonique.

Pour obtenir une LED présentant simultanément une bonne extraction de lumière et une bonne injection électrique, on propose ci-après de limiter le cristal photonique à une ou plusieurs zones de la couche semi-conductrice 4a qui sont éloignées par rapport à l'électrode 6a. La densité de courant dans ces zones étant faible, on peut les utiliser comme zones d'extraction de lumière sans diminuer drastiquement les performances électriques.

La figure 6 représente un mode de réalisation générique de cette diode électroluminescente à cristal photonique 18' localisé. Le cristal photonique 18' comporte ici une seule zone d'extraction de lumière.

Contrairement aux LED de l'art antérieur, le cristal photonique 18' occupe une faible portion de la couche semi-conductrice 4a en GaN. Ainsi, il n'interfère qu'avec un nombre restreint de lignes de courant. En outre, le cristal 18' est placé à une distance L de l'électrode 6a, pour qu'il s'agisse des lignes transportant le moins de courant.

Le cristal photonique 18' est formé en gravant des trous dans la couche 4a en GaN. Ces trous sont espacés périodiquement, de préférence dans au moins deux directions du plan de la couche 4a (cristal photonique 2D). La périodicité dans le cristal 18' est du même ordre de grandeur que la longueur d'onde d'émission de la LED. Une période du cristal photonique est choisie entre 200 nm et 2 $\mu$m pour une LED GaN.

Les dimensions de la zone d'extraction 18' correspondent, de préférence, à une dizaine de périodes environ, soit entre 2 $\mu$m et 10 $\mu$m. Ce faible nombre de périodes n'est pas préjudiciable pour l'extraction de la lumière. En effet, comme la lumière guidée se propage transversalement dans la LED, i.e. dans un plan parallèle au substrat, elle atteint nécessairement la zone d'extraction 18'.

Pour quantifier la distance L qui sépare le cristal photonique 18' de l'électrode supérieure 6a, on a étudié en détail le transport latéral du courant électrique dans la LED de la figure 5, à l'aide d'un modèle électrique tiré de l'article ["Current crowding in GaN/InGaN light emitting diodes on insulating substrates" ; X. Guo et al., Journal of Applied Physics, vol.90, num.8, 2001]. Dans ce modèle, une LED équivaut à un circuit électrique composé de résistances et de diodes. Les résistances du circuit correspondent aux résistances de contact (côté anode) et à la résistivité des couches de GaN dopé n ou p. Les diodes correspondent à la jonction p-n de la LED.

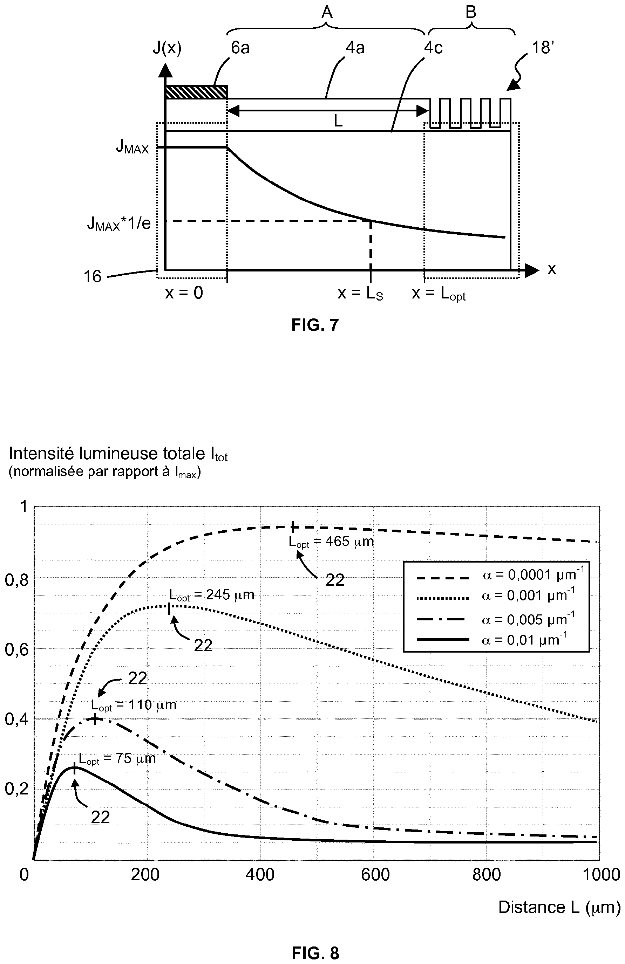

La figure 7 montre les résultats de cette étude. Elle superpose un schéma de LED selon la figure 6 avec un graphique de la densité de courant J(x) le long de la zone active 4c. L'axe des ordonnées correspond à la densité de courant J et l'axe des abscisses correspond à une position latérale x d'un point dans la zone active. Par convention, on a choisi comme point de départ pour la position x le bord de l'électrode 6a qui en retrait par rapport à une paroi latérale de la LED. Autrement dit, le bord droit de l'électrode 6a correspond à l'origine de l'axe des abscisses (x=0) sur la figure 7.

Dans la portion 16 de la zone active 4c située sous l'électrode 6a, c'est-à-dire pour des x négatifs, la densité de courant J est maximale. La variation de la densité dans cette zone est négligeable par rapport à la diminution de la densité en dehors de l'électrode. On peut donc raisonnablement supposer que la densité de courant dans la portion 16 de la zone active est constante et égale à la densité maximale $J_{MAX}$.

Par contre, la densité de courant J(x) dans la zone active d'une LED décroît brusquement à partir du bord de l'électrode (x=0). D'après le modèle électrique susmentionné, cette décroissance est exponentielle. La densité J(x) est donnée par la relation (1) suivante :

$$J(x) = J_{MAX} \exp\left(-\frac{x}{\sqrt{\dfrac{t_n\left(\rho_c t_c + \rho_p t_p\right)}{\rho_n}}}\right) \qquad (1),$$

dans laquelle figurent la résistivité $\rho_n$ et l'épaisseur $t_n$ de la couche en GaN dopé de type n (réf. 4a), la résistivité $\rho_p$ et l'épaisseur $t_p$ de la couche en GaN dopé de type p (réf. 4b sur la figure 6), la résistivité $\rho_c$ et l'épaisseur $t_c$ de l'électrode de contact 6a.

A partir de la relation (1), on définit une longueur d'atténuation latérale $L_S$ de la densité de courant comme étant la position x à laquelle la densité J est réduite d'un facteur 1/e par rapport à sa valeur maximale $J_{MAX}$ au bord de l'électrode, soit : $J(x = L_S) = J_{MAX} \cdot \exp(-1)$.

La longueur d'atténuation latérale $L_S$ s'exprime alors de la façon suivante :

$$L_S = \sqrt{\frac{t_n\left(\rho_c t_c + \rho_p t_p\right)}{\rho_n}} \qquad (2).$$

Maintenant que le modèle électrique est établi, il est possible d'exprimer la quantité de lumière générée par la LED et d'estimer pour quelle valeur de la distance L celle-ci est maximale (L étant la distance entre l'électrode 6a et le cristal photonique 18').

L'intensité lumineuse générée par la LED est proportionnelle à la densité de courant dans la zone active 4c. En plus de la densité J(x), on tient compte du phénomène d'absorption de la lumière par les matériaux semi-conducteurs des couches semi-conductrices 4a-4b et de la zone active 4c. En effet, une partie de la lumière émise est perdue lorsqu'elle se propage dans le plan des couches 4a-c.

L'intensité lumineuse totale de la LED a deux composantes :

- l'intensité lumineuse $I_A$ correspondant à la lumière extraite par la portion des couches 4a, 4b et 4c située entre l'électrode 6a et le cristal photonique 18' (zone A sur la figure 7) ; et

- l'intensité lumineuse $I_B$ correspondant à la lumière extraite par le cristal photonique 18' (zone B).

Chaque composante est pondérée par un coefficient d'extraction de la lumière dans la zone concernée. En considérant un indice de réfraction des couches 4a-4c de 2,5, l'efficacité d'extraction de la zone A, notée $\eta_A$, est faible, environ 5%. Par contre, le cristal photonique 18' est dimensionné pour que la quasi-totalité de la lumière guidée soit extraite. L'efficacité d'extraction $\eta_B$ dans la zone B avoisine donc 100 %.

Seule la zone A de la couche active 4c participe à l'émission de lumière. Dans la zone B, la couche active 4c n'émet quasiment plus de lumière, car la formation du cristal photonique nuit fortement à l'injection électrique.

Autrement dit, 95 % de la lumière émise dans la LED (i.e. zone A) reste piégée dans la LED et forme la lumière guidée. Cette lumière guidée est partiellement absorbée par les matériaux semi-conducteurs constituant les couches 4a à 4c, lors de son déplacement jusqu'à la zone B du cristal photonique. Arrivée dans la zone B, la lumière guidée restante est extraite quasiment sans pertes grâce au cristal photonique.

L'intensité lumineuse $I_A$ est proportionnelle à la densité de courant J(x) multipliée par l'efficacité d'extraction

$\eta_A$. Contrairement à la zone B, la lumière de la zone A n'est pratiquement pas soumise à l'absorption, elle est extraite immédiatement. On obtient donc la relation suivante :

$$I_A(x) \propto \eta_A \cdot J(x) \propto \eta_A \cdot \exp\left(-\frac{x}{L_S}\right) \qquad (3)$$

À cause de l'absorption, l'intensité lumineuse $I_B$ décroît de façon exponentielle en fonction de la distance parcourue par la lumière dans la zone A. En référence à la figure 7, la lumière est émise à une position x quelconque dans la zone A, puis est absorbée sur une distance L-x qui lui reste à parcourir pour atteindre le cristal photonique 18'.

L'intensité $I_B$ est ainsi proportionnelle à la densité de courant $J(x)$ multipliée par l'efficacité d'extraction $\eta_B-\eta_A$ et par le coefficient d'absorption de la lumière dans la structure GaN en zone A :

$$I_B(x) \propto \left(\eta_B - \eta_A\right) \cdot J(x) \cdot \exp[-\alpha(L - x)] \propto \left(\eta_B - \eta_A\right) \cdot \exp(-\alpha L) \cdot \exp\left[-\frac{x}{L_S}(1 - \alpha L_S)\right]$$
$$(4)$$

Pour connaître l'intensité totale $I_{tot}$ de la lumière extraite par les zones A et B, les intensités $I_A(x)$ et $I_B(x)$, exprimées pour une position x quelconque, sont intégrées entre 0 (bord droit de l'électrode) et L (bord gauche du cristal photonique). Au-delà de la position x=L, la zone active 4c est sacrifiée, au profit de l'extraction de lumière. Il n'y a donc pas de lumière émise.

Ainsi, en intégrant les relations (3) et (4) ci-dessus entre 0 et L, on obtient une relation approchée (à une constante près) de l'intensité totale de lumière en fonction de la distance L :

$$(5) \qquad I_{tot} \propto \int_O^L \eta_A \cdot \exp\left(-\frac{x}{L_S}\right) + \int_0^L \left(\eta_B - \eta_A\right) \cdot \exp(-\alpha L) \cdot \exp\left[-\frac{x}{L_S}(1 - \alpha L_S)\right]$$

$$\propto \eta_A \cdot L_S \cdot \left[1 - \exp\left(-\frac{L}{L_S}\right)\right] + \left(\eta_B - \eta_A\right) \cdot \frac{L_S}{1 - \alpha L_S} \cdot \exp(-\alpha L) \cdot \left(1 - \exp\left[-\frac{L}{L_S}(1 - \alpha L_S)\right]\right)$$

Les relations ci-dessus ne tiennent pas compte de la lumière émise sous l'électrode, i.e. la densité de courant $J_{max}$, car les dimensions de l'électrode sont faibles, largement inférieures à la distance L et aux dimensions du cristal photonique. La lumière émise sous l'électrode est donc négligeable.

La figure 8 est un graphe représentant l'intensité lumineuse $I_{tot}$ de la LED des figures 6 et 7 en fonction de la distance L entre l'électrode 6a et le cristal photonique 18', d'après la relation (5). Dans cet exemple, on a choisi une longueur d'atténuation latérale $L_S$ égale à 97 $\mu$m et différentes valeurs du coefficient d'absorption $\alpha$.

Ce graphe montre, pour chaque valeur de $\alpha$, qu'il existe un maximum d'intensité lumineuse 22. Pour des distances L trop faibles, c'est-à-dire avant le pic d'intensité lumineuse 22, la quantité de lumière est limitée, car le cristal photonique perturbe fortement l'injection électrique. À l'inverse, pour des longueurs L trop importantes, la quantité de lumière diminue rapidement à cause du phénomène d'absorption. La figure 8 illustre donc le compromis entre l'injection électrique et l'absorption de lumière dans l'intensité lumineuse d'une LED.

Il existe donc une position optimale à laquelle il faut placer le cristal photonique pour obtenir un maximum d'intensité lumineuse $I_{tot}$. Cette distance optimale entre le cristal photonique et l'électrode, notée $L_{opt}$ sur la figure 7, peut être déterminée pour chaque LED à l'aide de la relation (5) ci-dessus. La distance optimale $L_{opt}$ est par exemple obtenue en calculant la dérivée de $I_{tot}$ en fonction de L, soit $\dfrac{\partial I_{tot}}{\partial L}$, puis en résolvant l'équation :

$$\frac{\partial I_{tot}}{\partial L} = 0 \qquad (6)$$

La position optimale du cristal 18' par rapport à l'électrode 6a, i.e la solution de l'équation (6), s'écrit :

$$L_{opt} = \frac{L_S}{\alpha L_S - 1} \ln\left( \frac{(\eta_B - \eta_A) \cdot \alpha L_S}{\eta_B - \eta_A \alpha L_S} \right) \qquad (7)$$

Ainsi, pour optimiser la production de lumière par la LED verticale des figures 6 et 7, on place le cristal photonique 18' à une distance L de l'électrode 6a telle que $0{,}9.L_{opt} \le L \le 1{,}1.L_{opt}$. Autrement dit, on choisit une distance L vérifiant, avec une précision de 10 %, l'équation :

$$L = \frac{L_S}{\alpha L_S - 1} \ln\left( \frac{(\eta_B - \eta_A) \cdot \alpha L_S}{\eta_B - \eta_A \alpha L_S} \right)$$

dans laquelle :

- $L_S$ est la longueur d'atténuation latérale, soit la distance, depuis l'électrode, à laquelle la densité de courant dans la zone active électroluminescente est égale $J_{MAX}/\exp(1)$ ;

- $\alpha$ est le coefficient d'absorption des modes de lumière se propageant dans les couches 4a à 4c de la LED ;

- $\eta_A$ est le coefficient d'extraction de lumière dans la portion A des couches 4a à 4c ; et

- $\eta_B$ est le coefficient d'extraction de lumière dans la zone du cristal photonique (portion B).

Dans un mode de réalisation préférentiel, l'électrode supérieure 6a, ici la cathode, comprend une pluralité de pistes électriquement conductrices, afin d'homogénéiser l'injection de courant électrique dans la LED. Dans ce cas, le cristal photonique peut être éclaté en une pluralité de zones d'extraction 18', comme celle de la figure 6. Les zones d'extraction sont réparties dans la couche 4a en GaN et éloignées des pistes conductrices de l'électrode, de sorte à minimiser leur impact sur l'injection électrique. Bien sûr, chaque zone d'extraction peut être considérée comme un cristal photonique à part entière, puisqu'elles sont disjointes dans la couche 4a en GaN.

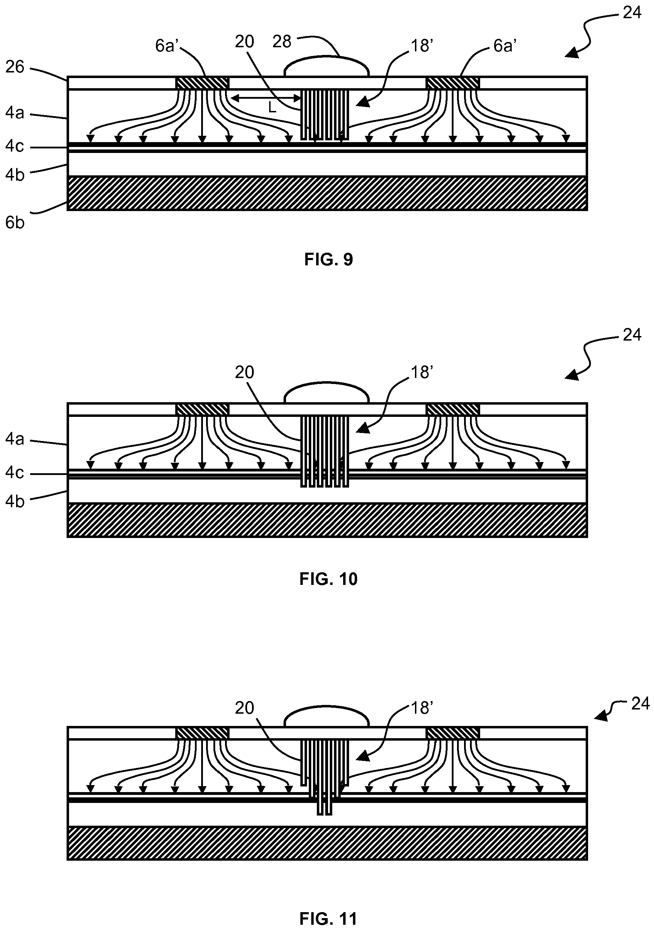

La figure 9 est une vue en coupe transversale d'une portion 24 de LED verticale, d'après ce mode de réalisation préférentiel. Par souci de clarté, seulement deux pistes électriquement conductrices 6a' et une zone d'extraction 18' sont représentées. La zone d'extraction 18' est située entre les deux pistes 6a', à une distance L d'au moins une piste conductrice, L vérifiant la relation $0{,}9.L_{opt} \le L \le 1{,}1.L_{opt}$. Avantageusement, la zone d'extraction 18' est située à équidistance des deux pistes conductrices 6a'.
La LED peut également comporter une couche d'aplanissement 26 disposé sur la couche 4a en GaN. La couche 26 est avantageusement de même épaisseur que les pistes conductrices 6a' et enrobe les faces latérales de ces pistes. Enfin, une lentille 28 en forme de dôme est avantageusement formée sur la couche 26, à la verticale de la zone d'extraction 18', pour mettre en forme le faisceau de lumière extrait de la LED.
Dans les modes de réalisation des figures 6 et 9, le cristal photonique 18' est gravé profondément dans la couche 4a en GaN jusqu'à la zone active 4c, sans toutefois la traverser. De préférence, la portion de la couche 4a séparant le fond du cristal photonique 18' de la zone active 4c mesure entre 10 nm à 2 μm d'épaisseur.
Dans une variante de réalisation représentée sur la figure 10, les trous 20 du cristal photonique 18' s'étendent dans la zone active 4c. Cela permet d'extraire davantage de lumière (tous les modes d'ordre inférieur ou égal à 5), notamment le mode fondamental. En effet, on réalise ainsi un couplage optique direct du mode fondamental avec le cristal photonique.
Cette structuration de la zone active 4c génère en contrepartie des centres de recombinaisons non-radiatives, ce qui diminue le rendement de la LED. Ce phénomène reste toutefois limité, puisque le cristal photonique occupe désormais des petites portions de la zone active.
Les trous 20 peuvent traverser la zone active 4c et déboucher dans la couche en GaN 4b (Fig.10). Alternativement, la gravure des trous 20 peut s'achever dans la zone active 4c (non représenté).
Dans les modes de réalisation des figures 9 et 10, les trous 20 d'une zone d'extraction 18' ont une forme et des dimensions identiques. Ils ont notamment la même profondeur.
La figure 11 représente, en coupe transversale, une autre variante de réalisation du cristal photonique 18', dans laquelle les trous 20 ont une profondeur variable. La profondeur augmente progressivement, de l'extérieur vers le centre de la zone d'extraction 18'. Cela permet d'adapter lentement l'indice de réfraction optique, limitant ainsi la réflexion de la lumière guidée par les parois des trous 20. Il en résulte un meilleur couplage de la lumière guidée au cristal photonique. Une variation progressive de la largeur des trous ou de la période du cristal photonique permet également d'obtenir ce meilleur couplage.

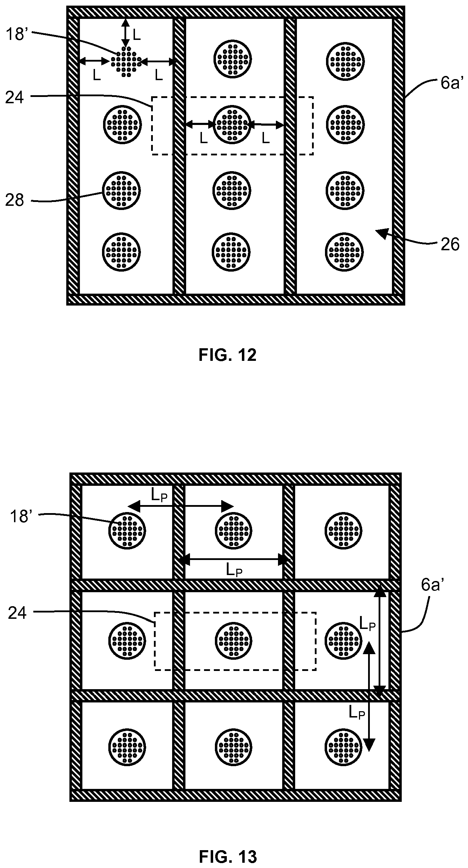

La figure 12 est une vue de dessus globale de la LED à cristaux photoniques localisés 18'. La portion 24 de la LED représentée en vue de coupe sur les figures 9 à 11 est repérée par un cadre en pointillés sur la figure 12. L'électrode supérieure comporte par exemple quatre pistes conductrices 6a' à la périphérie de la LED et deux pistes supplémentaires en travers de la couche 26, joignant deux côtés opposés de la LED. Ainsi, la surface de la LED est divisée en trois parties, de surface sensiblement constante.

Quatre zones d'extraction 18', recouvertes chacune d'une lentille 28, sont réparties dans chaque partie. De préférence, la distance de chaque zone d'extraction par rapport aux pistes 6a' adjacentes, est égale à la distance L définie ci-dessus ($0.9 \cdot L_{opt} \leq L \leq 1.1 \cdot L_{opt}$).

Comme cela est représenté sur la figure 12, les pistes électriquement conductrices 6a' sont, de préférence, interconnectées et reparties sur toute la surface de la couche en GaN. Elles sont alors soumises au même potentiel électrique, ce qui tend à uniformiser la densité de courant dans la zone active. Elles sont, par exemple, formées de métal (or, aluminium, nickel, titane), ou d'un alliage de plusieurs métaux.

Avec plusieurs pistes métalliques 6a', la densité de courant dans la zone active 4c est globalement plus élevée qu'avec une seule piste. En outre, la présence de plusieurs zones 18' réparties dans la couche 4a facilite l'extraction des photons, qui sont en plus grand nombre. En effet, ces derniers ont moins de distance à parcourir pour rejoindre une zone d'extraction, et ce quel que soit leur point d'émission dans la zone active.

Bien entendu, le nombre de pistes métalliques 6a' et le nombre de zones d'extraction 18' que comporte le cristal photonique peuvent varier d'une diode électroluminescente à l'autre, notamment en fonction des dimensions de la LED. D'une manière générale, plus la LED occupe une surface importante, plus les nombres de pistes conductrices et de zones d'extractions sont élevés.

La figure 13 est une deuxième vue de dessus de la LED verticale illustrant une autre façon de répartir les pistes métalliques 6a' de l'électrode et les zones d'extraction 18' du cristal photonique. Chaque zone 18' est entourée de quatre pistes métalliques 6a'. L'électrode supérieure forme ainsi un quadrillage à la surface de la LED. Les zones d'extraction 18' sont, de préférence, espacées d'une même distance L de leurs pistes métalliques 6a respectives.

Dans ce mode de réalisation, comme dans celui de la figure 12, la répartition zones d'extraction 18' et la répartition des couches métalliques 6a' dans la couche de GaN sont périodiques. La périodicité peut être réalisée selon les deux dimensions du plan de la couche 4a, comme sur la figure 13, ou dans une seule direction. Sur la figure 12 par exemple, cela se traduit par un groupe de quatre zones d'extraction 18' entouré de quatre pistes métalliques 6a' et reproduit trois fois sur la surface de la LED, de gauche à droite.

La distance entre deux zones d'extraction 18' consécutives, qui correspond donc à la période ou au pas de répétition de ces motifs, est de préférence comprise entre 1 $\mu$m et 500 $\mu$m. Elle est avantageusement inférieure à la distance moyenne parcourue par les photons avant qu'ils ne soient absorbés par le matériau semi-conducteur GaN. Cette distance peut être appelée le libre parcours moyen. Ainsi, un grand nombre de photons peut être extrait de la LED avant que leur énergie s'épuise dans le matériau semi-conducteur GaN.

Comme représentée sur la figure 13, la période $L_P$ des zones d'extraction 18' est, de préférence, égale à celle des pistes métalliques 6a'. Lorsque, en outre, toutes les zones 18' et toutes les pistes 6a ont des dimensions identiques, on obtient une répartition parfaitement symétrique à la surface de la LED. Dans ces conditions, l'injection électrique et l'extraction de lumière sont toutes les deux optimisées.

La LED à cristal (cristaux) photonique(s) localisé(s) des figures 6 à 13 a été décrite ci-dessus en relation avec une structure de type verticale. Rien n'empêche bien sûr de transposer ces modes de réalisation au cas d'une LED à structure MESA. Les relations de la densité de courant (1), de la longueur d'atténuation latérale (2) et de la longueur optimale $L_{opt}$ (7) sont inchangées, bien que l'empilement de couches semi-conductrice soit inversé.

Dans les diodes électroluminescentes GaN planes, la résistivité de la couche 4b dopée de type p est élevée par rapport à la résistivité de la couche 4a dopée de type n (respectivement de l'ordre de 2 $\Omega$.cm et de 0,011 $\Omega$.cm).

Or, dans la structure MESA, la couche 6b dopée p se situe au niveau de l'extraction de lumière, en contact avec l'électrode supérieure (anode 6b), et sa résistivité est en grande partie responsable de l'inhomogénéité du courant électrique dans la zone active.

Pour étaler le courant sur toute la surface de la LED, il est d'usage d'insérer, entre la couche 4b et l'anode 6b, une couche d'injection électrique transparente à la longueur d'onde d'émission et de conductivité électrique supérieure à celle la couche 6b. Cette couche d'injection, par exemple en ITO, vise à limiter les effets de concentration du courant (« current crowding » en anglais) et à uniformiser l'injection électrique, sans y parvenir totalement.

Cette couche d'injection additionnelle peut être prise en compte dans le modèle électrique de la densité de courant. C'est d'ailleurs l'objet de l'article ["Lateral current transport path, a model for GaN-based light-emitting diodes : Applications to pratical device designs" ; H. Kim et al., Applied Physics Letters, vol.81, num.7, 2002].

En tenant compte de la couche d'injection de courant, la relation de la densité de courant J(x) dans la zone active est modifiée comme suit :

$$J(x) = J_{MAX} \exp\left(-\frac{x}{\sqrt{\left(\rho_c t_c + \rho_p t_p\right)\left|\dfrac{\rho_n}{t_n} - \dfrac{\rho_e}{t_e}\right|^{-1}}}\right) \quad (1'),$$

avec $\rho_e$ la résistivité de la couche d'injection et $t_e$ son épaisseur.

La longueur d'atténuation latérale $L_S$ s'écrit alors :

$$L_S = \sqrt{\left(\rho_c t_c + \rho_p t_p\right)\left|\frac{\rho_n}{t_n} - \frac{\rho_e}{t_e}\right|^{-1}} \quad (2').$$

Dans une LED de type vertical, une couche d'injection est rarement utilisée car la couche 4b en GaN de type P est, en général, en contact avec un substrat électriquement conducteur jouant le rôle d'électrode sur toute sa surface. Par contre, si le substrat n'est pas conducteur, il est préférable d'utiliser la couche d'injection électrique, qui se présente alors sous la forme d'une couche en métal, entre le substrat et la couche 6b. Elle recouvre également toute la surface de la couche 6b et sert, en outre, de miroir pour réfléchir une partie de la lumière. Dans un cas comme dans l'autre, l'injection des trous dans la couche 6b en p-GaN est pratiquement homogène. Seule l'injection des électrons est responsable de l'inhomogénéité de la densité de courant dans la zone active.

La couche d'injection en métal d'une LED verticale dispose d'une résistivité $\rho_e$ bien plus faible que la résistivité $\rho_n$ de la couche 4a en n-GaN. Par conséquent, pour une LED verticale, le terme $\rho_e/t_e$ des relations (1') et (2') ci-dessus peut être négligé par rapport au terme $\rho_n/t_n$. On retombe alors sur les relations (1) et (2) précédentes.

En résumé, les relations (1) et (2) sont appropriées pour une LED avec mesa sans couche d'injection et tout type de LED verticale, tandis que les relations (1') et (2') sont à privilégier pour une LED MESA munie d'une couche d'injection des trous.

Le tableau 1 ci-dessous regroupe les valeurs des paramètres $\alpha$, $\rho_n$, $t_n$, $\rho_p$, $t_p$, $\rho_c$, $t_c$, $\rho_e$ et $t_e$ dans le cas de la LED GaN à structure verticale et d'une LED GaN à structure MESA (avec couche d'injection ; Fig.1) de mêmes dimensions. Bien entendu, les valeurs des paramètres sont données ici à titre d'exemple et peuvent varier selon les techniques de fabrication employées et le dopage des matériaux semi-conducteurs.

| | Structure MESA | Structure Verticale |
|---|---|---|
| Résistivité contact : $\varphi_c$ ($\Omega$.cm) | 17 | 17 |
| Epaisseur contact : $t_c$ (cm) | $3 \times 10^{-4}$ | $3 \times 10^{-4}$ |
| Résistivité électrode: $\varphi_e$ ($\Omega$.cm) | $2.5 \times 10^{-3}$ | $4 \times 10^{-6}$ |
| Epaisseur électrode : $t_e$ (cm) | $0.1 \times 10^{-4}$ | $0.1 \times 10^{-4}$ |
| Résistivité couche p : $\varphi_p$ ($\Omega$.cm) | 2 | 2 |
| Epaisseur couche p : $t_p$ (cm) | $0.2 \times 10^{-4}$ | $0.2 \times 10^{-4}$ |
| Résistivité couche n : $\varphi_n$ ($\Omega$.cm) | 0.011 | 0.011 |
| Epaisseur couche n : $t_n$ (cm) | $2 \times 10^{-4}$ | $2 \times 10^{-4}$ |
| Absorption : $\alpha$ ($\mu m^{-1}$) | $1 \times 10^{-3}$ | $1 \times 10^{-3}$ |
| | | |
| Longueur d'atténuation du courant d'injection : $L_s$ ($\mu m$) | 51 | 97 |
| Position optimale : $L_{opt}$ ($\mu m$) | 190 | 245 |

## Tableau 1

Pour chacune des LED, on a reporté dans le tableau 1 la distance d'atténuation latérale $L_S$ calculée à l'aide de la relation (2') (ou la relation simplifiée (2), selon le cas), et la distance optimale $L_{opt}$ calculée à l'aide la relation (7).

La longueur $L_S$ est égale à 97 $\mu$m environ dans le cas d'une LED verticale et à 51 $\mu$m environ dans le cas d'une LED MESA. La longueur $L_{opt}$ est égale à 190 $\mu$m environ dans le cas d'une LED verticale et à 245 $\mu$m environ dans le cas d'une LED MESA pour une absorption $\alpha$ de $10^{-3}$ $\mu m^{-1}$.

Pour former un cristal photonique, et ainsi extraire efficacement la lumière guidée hors de la LED, des trous sont gravés en profondeur dans la couche supérieure en GaN, avec une périodicité de l'ordre de la longueur d'onde d'émission de la LED. Les trous du cristal photonique peuvent être agencés selon une géométrie particulière. Cette géométrie est généralement choisie en fonction de l'angle d'extraction et de la polarisation que l'on souhaite donner à la lumière extraire.

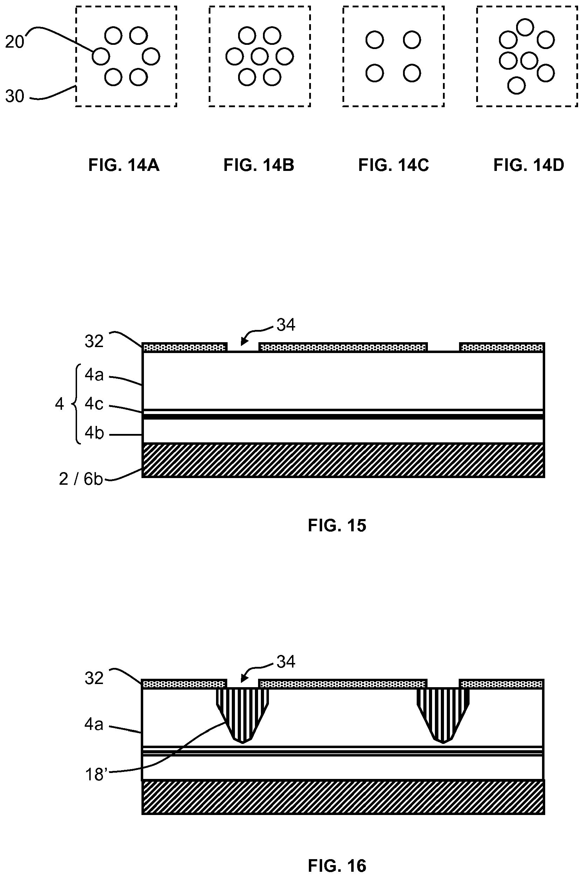

Les figures 14A à 14D représentent diverses géométries possibles de cristal photonique. Chaque géométrie correspond à un motif de forme différente, ce motif étant reproduit dans tout le cristal photonique, i.e dans toutes les zones d'extraction. Dans les motifs des figures 14A et 14B, les trous 20 dessinent un hexagone, avec ou sans trou à l'intérieur de l'hexagone. Sur la figure 14C, le motif a la forme d'un carré. Enfin, sur la figure 14D, aucune forme n'a été choisie. Les trous sont gravés aléatoirement, mais la distance entre les trous est, en moyenne, du même ordre de grandeur que la longueur d'onde. On pourrait qualifier cette géométrie de « aléatoirement périodique ». Une structuration complètement aléatoire extraira la lumière, mais de manière moins efficace. Une structure en ligne peut être également choisie pour un contrôle de la polarisation de la lumière émise.

De préférence, la période (moyenne) des trous dans le cristal photonique est telle que la lumière émise soit diffractée perpendiculairement au plan de la LED. Cette périodicité optimale peut être déterminée en réalisant une analyse spectrale de la lumière émise, pour la géométrie sélectionnée. Une analyse spectrale classique consiste à déterminer le point r d'un diagramme de bandes électromagnétiques (modes TE/TM), calculé par la méthode du spectre d'ondes planes (« plane wave-basis frequency-domain » en anglais).

A titre d'exemple, pour un cristal photonique avec une géométrie hexagonale, une période du cristal photonique est de l'ordre de 250 nm. Une période supérieure peut être utilisée pour obtenir un angle d'extraction de la lumière plus important, au détriment de la brillance de la LED. Une période inférieure à 250 nm (par exemple de 50 nm) aura pour résultat de créer une couche localisée anti-réflective favorable à l'extraction de lumière, mais peu efficace en comparaison d'une structuration périodique type cristal photonique.

Alors qu'une rugosité de surface peut être obtenue par une gravure humide, un cristal photonique est habituellement réalisé à l'aide d'une gravure sèche, fortement anisotrope, faisant intervenir un plasma de particules chargés. Or, cette technique de gravure présente un grand nombre d'inconvénients : augmentation des recombinaisons non-radiatives, nécessité de passiver les parois des zones gravées, gravure lente et très énergétique...

On décrit ci-après un procédé permettant de réaliser l'une quelconque des diodes électroluminescentes des figures 6 à 13. En outre, on expose une façon avantageuse de mettre en oeuvre l'étape de gravure des zones d'extraction 18' qui composent le cristal photonique. La technique de gravure utilisée consiste à rendre poreux le matériau GaN, par anodisation sous rayonnement ultraviolet. On peut donc parler de porosification, ou encore d'électroporosification. La particularité de cette gravure humide est qu'elle permet, dans certaines conditions, d'obtenir la périodicité nécessaire pour extraire efficacement la lumière guidée. On bénéficie alors des avantages des gravures humides, c'est-à-dire la rapidité et la simplicité de mise oeuvre, pour la formation de cristaux photoniques.

Les figures 15 à 18 représentent des étapes de fabrication d'une diode électroluminescente munie d'une ou plusieurs zones d'extraction localisées. Ces étapes concernent aussi bien une LED de type verticale qu'une LED de type MESA. Pour une LED MESA, le procédé de fabrication comprendra, en outre, une étape de gravure d'un puits dans les couches semi-conductrices, jusqu'à la couche en GaN dopé de type n, puis une étape de dépôt de la cathode au fond du puits.

Dans une première étape représentée à la figure 15, on prévoit un empilement 4 de couches en matériau semi-conducteur. Bien que deux couches en GaN, l'une dopée de type n (4a) et l'autre dopée de type p (4b), suffisent à former une jonction p-n, il est préférable de former en outre des structures de taille nanométrique pour favoriser l'émission de photons, tels que des puits quantiques (4c) en InGaN. Les couches de GaN et d'InGaN sont, par exemple, formées par épitaxie sur un substrat de croissance 2 en saphir. Éventuellement, le substrat de croissance 2 est remplacé par un substrat électriquement conducteur 6b pour former l'une des électrodes de la LED (exemple d'une LED verticale).

Un masque de gravure 32, par exemple en nitrure de silicium, est ensuite formé sur l'empilement 4 de couches semi-conductrices. Le masque 32 comprend une ou plusieurs ouvertures 34 (deux ouvertures 34 sur la figure 15) à travers lesquelles seront gravées les zones d'extraction de lumière. Les ouvertures 34 sont, de préférence, réparties dans le masque 32, de façon à obtenir plusieurs zones d'extraction distinctes et réparties sur toute la surface de la LED.

Le masque de gravure 32 peut être formé en déposant d'abord une couche de nitrure de silicium sur toute la surface de la LED, puis en gravant les ouvertures 34 dans cette couche.

Les ouvertures 34 peuvent être individuelles (une ouverture par trou 20) ou collectives (une ouverture par zone d'extraction 18') comme sur la figure 15. Les ouvertures 34 du masque ont, par exemple, une forme en cercle. Leur diamètre est avantageusement compris entre 10 nm à 10 $\mu$m, afin d'obtenir des motifs d'environ 10 nm à 20 $\mu$m de diamètre.

À l'étape de la figure 16, les zones d'extraction 18' du cristal photonique sont gravées au travers des évidements 34 du masque 32. Plusieurs techniques classiques de gravure peuvent être utilisées, notamment une gravure sèche par plasma. Cependant, dans un mode de mise en oeuvre préférentiel, la gravure du cristal photonique est obtenue par dissolution anodique.

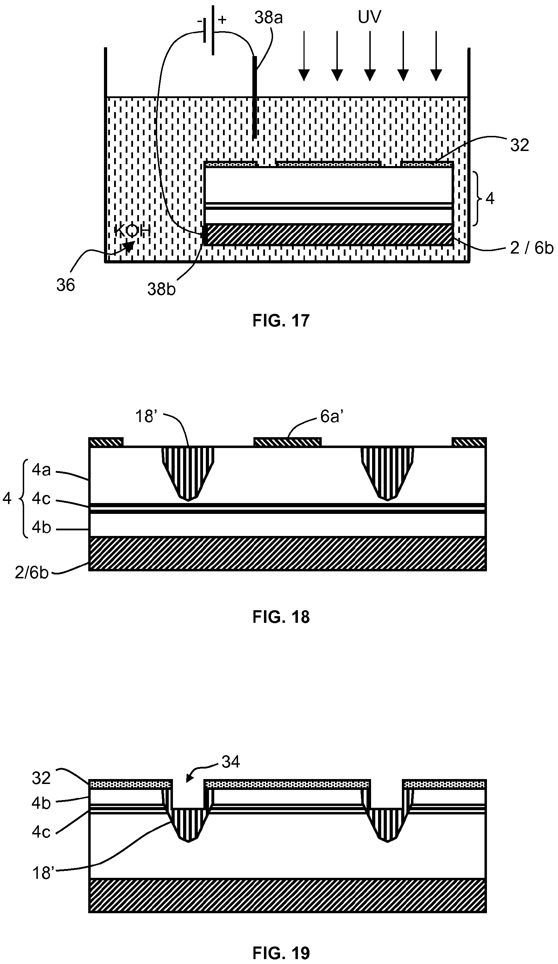

La figure 17 illustre un mode opératoire pour cette étape de traitement électrochimique par dissolution anodique. Il s'applique, bien entendu, quelles que soient la géométrie de la LED et la géométrie du masque de gravure (nombre d'évidements dans le masque notamment).

Le substrat sur lequel est formé l'empilement 4 de couches semi-conductrices, c'est-à-dire le substrat de croissance 2 ou le substrat conducteur 6b qui le remplace, est recouvert du masque de gravure 32, puis plongé dans un bain d'électrolyte 36 à base d'hydroxyde de potassium (KOH). Une première électrode 38a est plongée dans l'électrolyte 36 et une deuxième électrode 38b est agencée en contact le substrat 6b. Les électrodes permettent d'acheminer les porteurs de charge nécessaires à l'opération d'anodisation du GaN.

Lorsque le substrat n'est pas conducteur ou peu conducteur, dans une LED à structure MESA par exemple, l'électrode 38b est disposée pour être en contact électrique avec la couche de GaN située sur ce substrat (couche 4a en n-GaN sur la figure 1).

La porosification localisée à travers le masque de nitrure est, de préférence, réalisée dans un bain de KOH (hydroxyde de potassium) de concentration comprise entre 0,1 % à 50 % en poids, sous illumination ultra-violet (longueur d'onde de 100 à 400 nm, dose de 0 à 100 W/cm$^2$). La densité de courant utilisé pour rendre poreux le GaN (dopé de type n et p) varie de quelques mA/cm$^2$ à plusieurs A/cm$^2$ avec des tensions variant de 1 V à 200 V. Les temps de gravure sont de quelques dizaines de secondes à plusieurs heures. D'autres électrolytes peuvent être utilisés pour la porosification du GaN comme NaOH, $H_3PO_4$, HCl, $K_2S_2O_8$.

A l'issue de l'étape d'anodisation, on obtient des zones poreuses 18' dont les dimensions sous le masque 32 sont légèrement supérieures à celles des évidements 34 (Fig.16). Les pores des zones 18', de forme longitudinale, s'étendent verticalement dans la couche 4a de GaN.

Les pores sont espacés les uns des autres d'une distance moyenne comprise entre 5 nm à 1 $\mu$m. Autrement dit, les zones poreuses 18' obtenues par dissolution anodique peuvent présenter une périodicité moyenne du même ordre de grandeur que la longueur d'onde d'émission, ce qui les rend propices à l'extraction de lumière. En effet, l'indice de réfraction optique moyen des zones poreuses est inférieur à l'indice de réfraction du GaN massif, comme c'est également le cas pour l'indice moyen d'un cristal photonique gravé par plasma.

La gravure du cristal photonique par dissolution anodique s'applique aussi bien pour du GaN dopé de type n que du GaN dopé de type p. Par ailleurs, cette technique de gravure permet de contrôler aisément la forme et les dimensions des pores. A titre d'exemple, dans les conditions opératoires décrites ci-dessus, les pores ont une profondeur qui varie progressivement dans chaque zone poreuse 18', entre 10 nm à quelques micromètres de profondeur. Le profil de gravure en forme de « V » sur la figure 16 est également obtenu par les conditions opératoires décrites ci-dessus, c'est-à-dire en adaptant la concentration de KOH, la densité de courant, et le taux d'ouverture du masque.

En adaptant ainsi progressivement l'indice optique de chaque zone poreuse 18' aux différents modes de lumière guidée se propageant dans la LED, on évite qu'une partie de la lumière soit réfléchie par les zones 18'. Davantage de lumière guidée peut alors être extraite de la LED.

L'étape d'anodisation permet donc de réaliser facilement une géométrie similaire à celle proposée dans le document US2006/0192217, ce qui était délicat à mettre en oeuvre avec les techniques classiques de gravure.

A l'étape de la figure 18, le masque en nitrure de silicium est retiré, puis une électrode est formée à la surface de l'empilement 4 de couches en matériau semi-conducteur. De préférence, l'électrode est formée en déposant une pluralité de pistes 6a' électriquement conductrices sur la couche 4a en GaN.

Lorsque la LED comporte plusieurs zones d'extraction, comme cela est représenté sur la figure 18, une piste conductrice 6a' est de préférence disposée entre chaque couple de zones d'extraction 18' consécutives, et avantageusement à équidistance de ces deux zones. Des pistes électriquement conductrices 6a' peuvent aussi être disposées sur les bords de la LED, de sorte que toutes les zones 18' soient comprises entre deux pistes électriques 6a'. Une distance L voisine de $L_{opt}$ (relation (7)) sépare chaque zone d'extraction 18' des pistes conductrices 6a' qui lui sont adjacentes.

Si la LED ne comporte qu'une seule zone extraction, l'électrode peut être formée d'une seule piste conductrice. Alors, la zone d'extraction et l'électrode sont séparées d'une distance L telle que $0,9.L_{opt} \leq L \leq 1,1.L_{opt}$. L'unique zone d'extraction 18' peut aussi être située entre deux pistes conductrices, disposées de part et d'autre de la zone d'extraction, ou entourée par quatre pistes conductrices.

Le procédé décrit ci-dessus est particulièrement rapide et simple à mettre en oeuvre. La gravure du cristal photonique par dissolution anodique du matériau semi-conducteur permet un contrôle précis des paramètres géométriques des zones d'extraction : dimensions des pores, périodicité moyenne des pores et forme des zones porosifiées. On peut alors obtenir un cristal photonique dont la géométrie est optimisée pour l'extraction de lumière, tout en s'affranchissant des difficultés de mise en oeuvre.

La figure 19 représente une variante de mise en oeuvre de l'étape de la figure 15, pour la réalisation d'une LED à structure MESA ou verticale.

Après l'ouverture du masque 32 en nitrure de silicium mais avant la porosification, des couches semi-conductrices, et plus particulièrement la couche 4b en p-GaN (structure MESA de la figure 19) ou la couche 4a en n-GaN (structure verticale de la figure 15), sont gravées afin de donner une forme particulière aux zones porosifiées. Dans le cas de la LED verticale (Fig.15), la couche 4b en p-GaN et la couche active 4c peuvent aussi être gravées avant porosification pour faciliter l'obtention d'une forme en « V » (par exemple lorsque le contrôle de la concentration en KOH, de la densité de courant, et du taux d'ouverture du masque ne suffit plus).

De nombreuses variantes et modifications de la diode électroluminescente à cristal photonique localisé apparaîtront à l'homme du métier. Bien que la LED et son procédé de réalisation aient été décrits en relation avec des matériaux à base de nitrure de gallium, d'autres matériaux semi-conducteurs peuvent être utilisé, notamment les matériaux à base d'arséniure de gallium (GaAs), de phosphure de gallium (GaP) et de phosphure d'indium (InP). On peut donc obtenir des diodes électroluminescentes à cristal photonique localisé de haute brillance, avec diverses longueurs d'onde d'émission.

**Revendications**

**1.** Diode électroluminescente (LED) comprenant :

- une première couche (4a) en matériau semi-conducteur dopé d'un premier type de conductivité ;
- une deuxième couche (4b) en matériau semi-conducteur dopé d'un second type de conductivité opposé ;
- une zone active électroluminescente (4c) située entre les première et deuxième couches en matériau semi-conducteur ;
- une électrode (6a) disposée sur la première couche en matériau semi-conducteur ; et
- un cristal photonique (18') formé dans la première couche (4a) en matériau semi-conducteur ;

diode **caractérisée en ce que** le cristal photonique (18') et l'électrode (6a) sont séparés d'une distance L vérifiant, avec une précision de 10 %, l'équation suivante :

$$L = \frac{L_S}{\alpha L_S - 1} \ln\left(\frac{(\eta_B - \eta_A)\cdot \alpha L_S}{\eta_B - \eta_A \alpha L_S}\right)$$

dans laquelle :

- $L_S$ est la distance, depuis l'électrode, à laquelle la densité de courant dans la zone active électroluminescente (4c) est égale à la densité de courant ($J_{MAX}$) sous l'électrode (6a) réduite d'un facteur 1/e ;
- $\alpha$ est le coefficient d'absorption des modes de lumière se propageant dans les première et deuxième couches (4a, 4b) en matériau semi-conducteur et dans la zone active électroluminescente (4c) ;
- $\eta_A$ est le coefficient d'extraction de lumière dans une portion (A) des première et deuxième couches (4a, 4b) en matériau semi-conducteur et de la zone active électroluminescente (4c), située entre l'électrode (6a) et le cristal photonique (18') ; et
- $\eta_B$ est le coefficient d'extraction de lumière dans la zone (B) du cristal photonique (18').

2. Diode selon la revendication 1, dans laquelle l'électrode (6a) comporte une pluralité de pistes électriquement conductrices (6a') et dans laquelle le cristal photonique comporte une pluralité de zones d'extraction (18') de lumière réparties dans la première couche (4a) en matériau semi-conducteur, chaque zone d'extraction étant comprise entre deux pistes électriquement conductrices.

3. Diode selon la revendication 2, dans laquelle chaque zone d'extraction (18') est située à équidistance des deux pistes électriquement conductrices.

4. Diode selon l'une des revendications 2 et 3, dans laquelle la répartition des zones d'extraction (18') dans la première couche (4a) en matériau semi-conducteur est périodique.

5. Diode selon l'une quelconque des revendications 2 à 4, dans laquelle deux zones d'extraction (18') consécutives sont séparées d'une distance inférieure à la distance moyenne parcourue par des photons avant absorption dans le matériau semi-conducteur.

6. Diode selon l'une quelconque des revendications 1 à 5, dans laquelle le cristal photonique (18') comporte des trous (20) espacés périodiquement et s'étendant à travers la première couche (4a) en matériau semi-conducteur jusqu'à la zone active électroluminescente (4c).

7. Diode selon la revendication 6, dans laquelle les trous (20) du cristal photonique (18') s'étendent à travers la zone active électroluminescente (4c).

8. Diode selon l'une des revendications 6 et 7, dans laquelle les trous (20) du cristal photonique (18') ont une profondeur variant progressivement.

9. Procédé de formation d'une diode électroluminescente comprenant les étapes suivantes :

- prévoir une première couche (4a) en matériau semi-conducteur dopé d'un premier type de conductivité, une deuxième couche (4b) en matériau semi-conducteur dopé d'un second type de conductivité opposé et une zone active électroluminescente (4c) située entre les première et deuxième couches en matériau semi-conducteur ;
- former une électrode (6a) sur la première couche (4a) en matériau semi-conducteur ; et
- graver un cristal photonique (18') dans la première couche (4a) en matériau semi-conducteur, **caractérisé en ce que** le cristal photonique (18') et l'électrode (6a) sont séparés d'une distance L vérifiant, avec une précision de 10 %, l'équation suivante :

$$L = \frac{L_S}{\alpha L_S - 1} \ln\left(\frac{(\eta_B - \eta_A)\cdot \alpha L_S}{\eta_B - \eta_A \alpha L_S}\right)$$

dans laquelle :

• $L_S$ est la distance, depuis l'électrode, à laquelle la densité de courant dans la zone active électroluminescente (4c) est égale à la densité de courant ($J_{MAX}$) sous l'électrode (6a) réduite d'un facteur 1/e ;
• $\alpha$ est le coefficient d'absorption des modes de lumière se propageant dans les première et deuxième couches (4a, 4b) en matériau semi-conducteur et dans la zone active électroluminescente (4c) ;
• $\eta_A$ est le coefficient d'extraction de lumière dans une portion (A) des première et deuxième couches (4a, 4b) en matériau semi-conducteur et de la zone active électroluminescente (4c), située entre l'électrode (6a) et le cristal photonique (18') ; et
• $\eta_B$ est le coefficient d'extraction de lumière dans la zone (B) du cristal photonique (18').

10. Procédé selon la revendication 9, dans lequel le cristal photonique est gravé au travers d'un masque (32) comportant une pluralité d'évidements (34), d'où il résulte une pluralité de zones d'extraction (18') de lumière réparties dans la première couche (4a) en matériau semi-conducteur.

11. Procédé selon la revendication 10, dans lequel l'électrode (6a) est formée d'une pluralité de pistes électriquement conductrices (6a'), une piste étant disposée entre chaque couple de zones d'extraction (18') consécutives.

12. Procédé selon l'une des revendications 10 et 11, dans lequel la gravure du cristal photonique (18') est obtenue par dissolution anodique sous ultraviolets de la couche en matériau semi-conducteur (4a).

## Patentansprüche

1. Leuchtdiode (LED), umfassend

- eine erste Schicht (4a) aus Halbleitermaterial, das mit einem ersten Leitfähigkeitstyp dotiert ist;
- eine zweite Schicht (4b) aus Halbleitermaterial, das mit einem entgegengesetzten zweiten Leitfähigkeitstyp dotiert ist;
- einen elektrolumineszierenden aktiven Bereich (4c), der zwischen der ersten und der zweiten Schicht aus Halbleitermaterial gelegen ist;
- eine Elektrode (6a), die auf der ersten Schicht aus Halbleitermaterial angeordnet ist, und
- einen photonischen Kristall (18'), der in der ersten Schicht (4a) aus Halbleitermaterial ausgebildet ist;

Diode, **dadurch gekennzeichnet, dass** der photonische Kristall (18') und die Elektrode (6a) um einen Abstand L getrennt sind, der mit einer Genauigkeit von 10 % die folgende Gleichung erfüllt:

$$L = \frac{L_S}{\alpha L_S - 1} \ln\left( \frac{(\eta_B - \eta_A) \cdot \alpha L_S}{\eta_B - \eta_A \alpha L_S} \right)$$

worin:

• $L_S$ der Abstand von der Elektrode aus ist, in dem die Stromdichte in dem elektrolumineszierenden aktiven Bereich (4c) gleich der Stromdichte ($J_{MAX}$) unter der Elektrode (6a), verringert um einen Faktor 1/e, ist;
• $\alpha$ der Absorptionskoeffizient der Lichtmoden ist, die sich in der ersten und der zweiten Schicht (4a, 4b) aus Halbleitermaterial und in dem elektrolumineszierenden aktiven Bereich (4c) ausbreiten;
• $\eta_a$ der Lichtextraktionskoeffizient in einem Abschnitt (A) der ersten und der zweiten Schicht (4a, 4b) aus Halbleitermaterial und des zwischen der Elektrode (6a) und dem photonischen Kristall (18') gelegenen elektrolumineszierenden aktiven Bereichs (4c) ist; und
• $\eta_b$ der Lichtextraktionskoeffizient in dem Bereich (B) des photonischen Kristalls (18') ist.

2. Diode nach Anspruch 1, bei der die Elektrode (6a) eine Vielzahl von elektrisch leitenden Bahnen (6a') umfasst und bei der der photonische Kristall eine Vielzahl von Lichtextraktionsbereichen (18'), die in der ersten Schicht (4a) aus Halbleitermaterial verteilt sind, umfasst, wobei jeder Extraktionsbereich zwischen zwei elektrisch leitenden Bahnen gelegen ist.

3. Diode nach Anspruch 2, bei der jeder Extraktionsbereich (18') in gleichem Abstand von den beiden elektrisch leitenden Bahnen gelegen ist.

**4.** Diode nach einem der Ansprüche 2 und 3, bei der die Verteilung der Extraktionsbereiche (18') in der ersten Schicht (4a) aus Halbleitermaterial periodisch ist.

**5.** Diode nach einem der Ansprüche 2 bis 4, bei der zwei aufeinanderfolgende Extraktionsbereiche (18') um einen Abstand getrennt sind, der kleiner als die durch Photonen vor Absorption in dem Halbleitermaterial zurückgelegte mittlere Strecke ist.

**6.** Diode nach einem der Ansprüche 1 bis 5, bei der der photonische Kristall (18') Löcher (20) umfasst, die periodisch beabstandet sind und sich durch die erste Schicht (4a) aus Halbleitermaterial bis zu dem elektrolumineszierenden aktiven Bereich (4c) erstrecken.

**7.** Diode nach Anspruch 6, bei der die Löcher (20) des photonischen Kristalls (18') sich durch den elektrolumineszierenden aktiven Bereich (4c) erstrecken.

**8.** Diode nach einem der Ansprüche 6 und 7, bei der die Löcher (20) des photonischen Kristalls (18') eine schrittweise variierende Tiefe aufweisen.

**9.** Verfahren zur Ausbildung einer Leuchtdiode, das die folgenden Schritte umfasst:

- Vorsehen einer ersten Schicht (4a) aus Halbleitermaterial, das mit einem ersten Leitfähigkeitstyp dotiert ist, einer zweiten Schicht (4b) aus Halbleitermaterial, das mit einem entgegengesetzten zweiten Leitfähigkeitstyp dotiert ist, und eines elektrolumineszierenden aktiven Bereichs (4c), der zwischen der ersten und der zweiten Schicht aus Halbleitermaterial gelegen ist;
- Ausbilden einer Elektrode (6a) auf der ersten Schicht (4a) aus Halbleitermaterial und
- Ätzen eines photonischen Kristalls (18') in die erste Schicht (4a) aus Halbleitermaterial,

**dadurch gekennzeichnet, dass** der photonische Kristall (18') und die Elektrode (6a) um einen Abstand L getrennt sind, der mit einer Genauigkeit von 10 % die folgende Gleichung erfüllt:

$$ L = \frac{L_S}{\alpha L_S - 1} \ln\left( \frac{(\eta_B - \eta_A) \cdot \alpha L_S}{\eta_B - \eta_A \alpha L_S} \right) $$

worin:

• $L_S$ der Abstand von der Elektrode aus ist, in dem die Stromdichte in dem elektrolumineszierenden aktiven Bereich (4c) gleich der Stromdichte ($J_{MAX}$) unter der Elektrode (6a), verringert um einen Faktor 1/e, ist;
• $\alpha$ der Absorptionskoeffizient der Lichtmoden ist, die sich in der ersten und der zweiten Schicht (4a, 4b) aus Halbleitermaterial und in dem elektrolumineszierenden aktiven Bereich (4c) ausbreiten;
• $\eta_a$ der Lichtextraktionskoeffizient in einem Abschnitt (A) der ersten und der zweiten Schicht (4a, 4b) aus Halbleitermaterial und des zwischen der Elektrode (6a) und dem photonischen Kristall (18') gelegenen elektrolumineszierenden aktiven Bereichs (4c) ist; und
• $\eta_b$ der Lichtextraktionskoeffizient in dem Bereich (B) des photonischen Kristalls (18') ist.

**10.** Verfahren nach Anspruch 9, bei dem der photonische Kristall durch eine Maske (32) mit einer Vielzahl von Ausnehmungen (34) geätzt ist, woraus eine Vielzahl von Lichtextraktionsbereichen (18'), die in der ersten Schicht (4a) aus Halbleitermaterial verteilt sind, resultiert.

**11.** Verfahren nach Anspruch 10, bei dem die Elektrode (6a) von einer Vielzahl von elektrisch leitenden Bahnen (6a') gebildet ist, wobei eine Bahn zwischen jedem Paar von aufeinanderfolgenden Extraktionsbereichen (18') angeordnet ist.

**12.** Verfahren nach einem der Ansprüche 10 und 11, bei dem das Ätzen des photonischen Kristalls (18') durch anodische Auflösung unter UV der Halbleitermaterialschicht (4a) erreicht wird.

**Claims**

1. Light-emitting diode (LED) comprising:

   - a first layer (4a) of a doped semiconductor material of a first conductivity type;
   - a second layer (4b) of a doped semiconductor material of a second opposite conductivity type;
   - an active light-emitting area (4c) located between the first and second layers of semiconductor material;
   - an electrode (6a) arranged on the first layer of semiconductor material; and
   - a photonic crystal (18') formed in the first layer (4a) of semiconductor material;

   a diode **characterized in that** the photonic crystal (18') and the electrode (6a) are separated by a distance L verifying, to within 10% precision, the following equation:

   $$L = \frac{L_S}{\alpha L_S - 1} \ln\left( \frac{(\eta_B - \eta_A) \cdot \alpha L_S}{\eta_B - \eta_A \alpha L_S} \right)$$

   wherein:

   - $L_S$ is the distance, from the electrode, at which the current density in the active light-emitting area (4c) is equal to the current density ($J_{MAX}$) under the electrode (6a) reduced by a factor 1/e;
   - $\alpha$ is the absorption coefficient of the light modes propagating in the first and second layers (4a, 4b) of semiconductor material and in the active light-emitting area (4c);
   - $\eta_A$ is the light extraction coefficient in a portion (A) of the first and second layers (4a, 4b) of semiconductor material and of the active light-emitting area (4c), located between the electrode (6a) and the photonic crystal (18'); and
   - $\eta_B$ is the light extraction coefficient in the area (B) of the photonic crystal (18').

2. Diode according to claim 1, wherein the electrode (6a) comprises a plurality of electrically-conductive tracks (6a') and wherein the photonic crystal comprises a plurality of light extraction areas (18') distributed in the first semiconductor material layer (4a), each extraction area being located between two electrically-conductive tracks.

3. Diode according to claim 2, wherein each extraction area (18') is located at an equal distance from the two electrically-conductive tracks.

4. Diode according to any of claims 2 and 3, wherein the distribution of the extraction areas (18') in the first semiconductor material layer (4a) is periodic.

5. Diode according to any of claims 2 to 4, wherein two consecutive extraction areas (18') are separated by a distance shorter than the average distance traveled by photons before they are absorbed in the semiconductor material.

6. Diode according to any of claims 1 to 5, wherein the photonic crystal (18') comprises periodically spaced apart holes (20) extending through the first layer (4a) of semiconductor material all the way to the active light-emitting area (4c).

7. Diode according to claim 6, wherein the holes (20) of the photonic crystal (18') extend through the active light-emitting area (4c).

8. Diode according to any of claims 6 and 7, wherein the holes (20) of the photonic crystal (18') have a progressively-varying depth.

9. Method of manufacturing a light-emitting diode comprising the steps of:

   - providing a first layer (4a) of a doped semiconductor material of a first conductivity type, a second layer (4b) of a doped semiconductor material of a second opposite conductivity type, and an active light-emitting area (4c) located between the first and second layers of semiconductor material;
   - forming an electrode (6a) on the first layer (4a) of semiconductor material; and
   - etching a photonic crystal (18') in the first layer (4a) of semiconductor material, **characterized in that** the photonic crystal (18') and the electrode (6a) are separated by a distance L verifying, to within 10% precision, the following equation:

$$L = \frac{L_S}{\alpha L_S - 1} \ln\left(\frac{(\eta_B - \eta_A) \cdot \alpha L_S}{\eta_B - \eta_A \alpha L_S}\right)$$

wherein:

- $L_S$ is the distance, from the electrode, at which the current density in the active light-emitting area (4c) is equal to the current density ($J_{MAX}$) under the electrode (6a) reduced by a factor 1/e;
- $\alpha$ is the absorption coefficient of the light modes propagating in the first and second layers (4a, 4b) of semiconductor material and in the active light-emitting area (4c);
- $\eta_A$ is the light extraction coefficient in a portion (A) of the first and second layers (4a, 4b) of semiconductor material and of the active light-emitting area (4c), located between the electrode (6a) and the photonic crystal (18'); and
- $\eta_B$ is the light extraction coefficient in the area (B) of the photonic crystal (18').

10. Method according to claim 9, wherein the photonic crystal is etched through a mask (32) comprising a plurality of recesses (34), which results in a plurality of light extraction areas (18') distributed in the first semiconductor material layer (4a).

11. Method according to claim 10, wherein the electrode (6a) is formed of a plurality of electrically-conductive tracks (6a'), one track being arranged between each pair of consecutive extraction areas (18').

12. Method according to any of claims 10 and 11, wherein the etching of the photonic crystal (18') is obtained by anode dissolution under ultraviolet rays of the layer of semiconductor material (4a).

FIG. 1 (Art antérieur)

FIG. 2 (Art antérieur)

FIG. 3 (Art antérieur)

EP 2 846 366 B1

**FIG. 4 (Art antérieur)**

**FIG. 5**

**FIG. 6**

21

FIG. 7

Intensité lumineuse totale $I_{tot}$
(normalisée par rapport à $I_{max}$)

FIG. 8

**FIG. 9**

**FIG. 10**

**FIG. 11**

**FIG. 12**

**FIG. 13**

FIG. 14A  FIG. 14B  FIG. 14C  FIG. 14D

FIG. 15

FIG. 16

**FIG. 17**

**FIG. 18**

**FIG. 19**

## RÉFÉRENCES CITÉES DANS LA DESCRIPTION

**Documents brevets cités dans la description**

- US 20060192217 A

**Littérature non-brevet citée dans la description**

- **X. GUO et al.** Current crowding in GaN/InGaN light emitting diodes on insulating substrates. *Journal of Applied Physics,* 2001, vol. 90 (8

- **H. KIM et al.** Lateral current transport path, a model for GaN-based light-emitting diodes : Applications to pratical device designs. *Applied Physics Letters,* 2002, vol. 81 (7